# EUROPEAN PATENT SPECIFICATION

(11) **EP 2 221 971 B1**
(45) Date of publication and mention of the grant of the patent: **27.06.2012**
(21) Application number: 09002246.8
(22) Date of filing: 18.02.2009
(51) Int. Cl.: H03K 17/08, H03G 11/08

(54) **Inrush current generator for a supervisory relay of relay interlockings**
Einschaltstromgenerator für ein Kontrollrelais von Relaisverriegelungen
Générateur de courant d'appel pour un relais de surveillance de verrouillages de relais

(43) Date of publication of application: 25.08.2010
(73) Proprietor: Thales Deutschland GmbH, 70435 Stuttgart (DE)
(72) Inventor: Baumgartner, Dieter, 1120 Wien (AT); Telefont, Heinz, 3500 Krems (AT)
(74) Representative: Kohler Schmid Möbus

(56) References cited:
- US-A- 4 540 894

## Description

### Background of the invention

The invention relates to an inrush current generator for a supervisory relay of a relay interlocking system.

In signal lamp circuits the proper function of switching on signal lamps is verified by checking the lamp current. Usually a signal voltage of 230V AC is switched to the signal pylon, where a lamp transformer provides the 12V AC voltage for the appropriate signal lamp. The check of the lamp current takes place at relay interlockings via one or more supervisory relays, which are in series with the lamp circuit. Such supervisory relays have a pull-in voltage higher than the holding voltage and the drop-off voltage, respectively. This relay feature is used in relay interlockings, when classical signal lamps, which have an initial inrush current, are in use. This initial inrush current causes the supervisory relay to pull-in and, when the inrush current is over, the steady current is high enough to hold the supervisory relay. However, DC signal lamps such as LEDs do not provide such an inrush current and therefore the pulling-in of the supervisory relay may fail.

### Object of the invention

It is the object of the invention to provide a method and a relay interlocking system for supervising an AC current signal applied to a lamp circuit for driving a DC signal lamp.

### Short description of the invention

This object is achieved, in accordance with the invention, by an inrush current generator for a supervisory relay of a relay interlocking system, comprising:
two generator connections for connecting the inrush current generator to an alternating input voltage, and
two electronic circuits, one for the positive and one for the negative half-wave of the alternating input voltage, comprising each:
a high gain low impedance switch formed by at least one transistor with reverse diode, each transistor being connected to one generator connection and to the other generator connection via the reverse diode of the other transistor, and
a capacitor connected on the one side to one generator connection via a resistor and on the other side to the other generator connection via a diode, for being loaded by the alternating input voltage during the respective half-wave,
wherein the high gain low impedance switch is switched on until the capacitor is loaded to cause an inrush current between the two generator connections.

According to the invention, the electronic inrush current generator is connected in parallel to the lamp circuit for driving a DC signal lamp.

When the AC signal voltage is switched on, the inrush current generator lowers the input resistance for a few cycles and becomes ineffective afterwards. The AC current signal is increased by an inrush current of the inrush current generator up to a level sufficient to pull in a supervisory relay of the relay interlocking system connected in parallel with the lamp circuit and afterwards is high enough to hold the supervisory relay.

In other words, the inrush current generator emulates the inrush current of a conventional AC signal lamp and, therefore, makes it possible to use conventional relay interlocking systems also for DC signal lamps.

Further advantages can be extracted from the description and the enclosed drawing. The features mentioned above and below can be used in accordance with the invention either individually or collectively in any combination. The embodiments mentioned are not to be understood as an exhaustive enumeration but rather have exemplary character for the description of the invention.

### Drawing

The invention is shown in the drawing, in which:
- Fig. 1: shows schematically a relay interlocking system according to the invention for supervising an AC current signal provided as control input for a lamp circuit for driving a DC signal lamp;
- Fig. 2: an inrush current generator according to the invention, shown in Fig. 1;
- Fig. 3: the AC current signal generated by a lamp transformer shown in Fig. 1 and the inrush current generator of Fig. 2; and
- Fig. 4: the inrush current present in the AC current signal shown in Fig. 3.

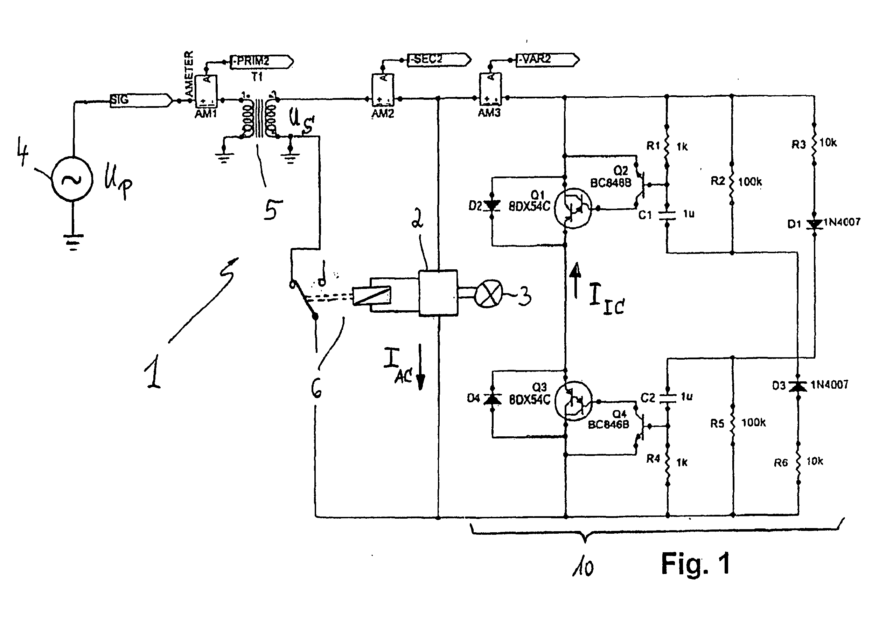

**Fig. 1** shows a relay interlocking system **1** for supervising the AC current signal I_{AC} provided as control input for a lamp circuit **2** for driving a DC signal lamp 3. The DC signal lamp 3 can be formed, for example, by one or more LEDs.

The relay interlocking system 1 comprises:
an AC voltage source **4** of 230V AC (50Hz) primary signal voltage **U**p,
a lamp transformer **5** for transforming the primary signal voltage U_{P} at the primary side to a 12V AC secondary signal voltage **U**_{S} at the secondary side of the lamp transformer 5, for generating an AC current signal I_{AC} as control input for the lamp circuit 2,
a supervisory relay **6** connected in series to the lamp circuit 2, for supervising the AC current signal I_{AC} applied to the lamp circuit 2, the lamp circuit 2 and the supervisory relay 6 being connected in series to the secondary side of the lamp transformer 5, and
an inrush current generator **10** connected in parallel with the lamp circuit 2, for generating an additional inrush current I_{IC} to increase the AC current signal I_{AC}.
The primary signal voltage U_{P} is used to provide the energy for the lamp circuit 2.

As shown in Fig. 1, the relay contact of supervisory relay 6 is connected in series with the lamp circuit 2. The operation position is on as shown. In case of errors in the lamp circuit 2 or in the signal lamp 3, the supervisory relay 6 shuts permanently down for safety reasons.

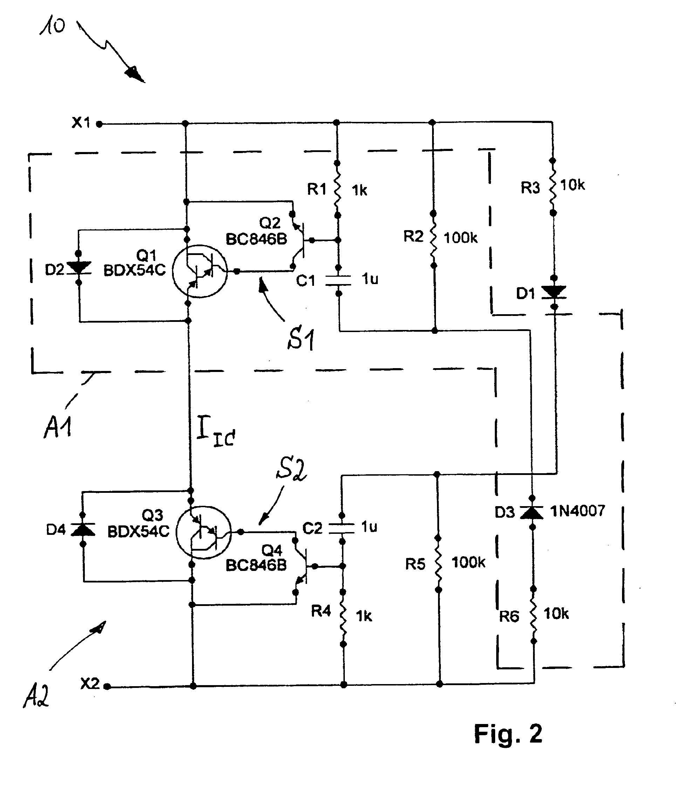

As shown in detail in **Fig. 2****,** the inrush current generator 10 comprises:
two generator connections **X1, X2** for connecting the inrush current generator 10 to the secondary signal voltage U_{S}, and
two identical electronic circuits **A1, A2,** one for the positive and one for the negative half-wave of the alternating secondary signal voltage U_{S}.
Each electronic circuit A1, A2 comprises:
a high gain low impedance switch **S1, S2** formed by both a pnp Darlington-transistor **Q1, Q3** with integrated reverse diode **D2, D4,** and a npn transistor **Q2, Q4,** the base of the Darlington-transistor Q1, Q3 being connected to the transistor Q2, Q4, each transistor Q1, Q3 being connected to one generator connection X1, X2 and to the other generator connection X2, X1 via the reverse diode D2; D4 of the other transistor Q3; Q1, and
a capacitor **C1, C2** connected on the one side to one generator connection X1, X2 via a resistor **R1**; **R4** and on the other side to the other generator connection X2, X1 via a diode **D3, D1** and a resistor **R6**; **R3,** for being loaded by the alternating input voltage U_{S} during the respective half-wave, the base of the transistor Q2, Q4 being connected to the capacitor C1, C2.
A further resistor **R2, R5** is connected in parallel to capacitor C1, C2 and resistor R1, R4.

In the electronic circuit A1, if the input voltage U_{S} is connected to the generator connections X1, X2, the capacitor C1 is loaded by the negative half-waves through R6, D3, R1 and the base current by transistor Q2. During this time the low impedance switch S1 is switched on and the "inrush current circuit" is closed via diode D4 and Darlington-transistor Q1 to cause the inrush current I_{IC} between the two generator connections X1, X2. After the capacitor C1 is fully loaded, Darlington-transistor Q1 switches off. When the electronic circuit A1 is disconnected from the input voltage U_{S}, resistor R2 resets capacitor C1 to the starting level.
In the electronic circuit A2, if the input voltage U_{S} is connected to the generator connections X1, X2, the capacitor C2 is loaded by the positive half-waves through R3, D1, R4 and the base current by transistor Q4. During this time the low impedance switch S2 is switched on and the "inrush current circuit" is closed via diode D2 and Darlington-transistor Q3 to cause the inrush current I_{IC} between the two generator connections X1, X2. After the capacitor C2 is fully loaded, Darlington-transistor Q3 switches off. When the electronic circuit A2 is disconnected from the input voltage U_{S}, resistor R5 resets capacitor C2 to the starting level.

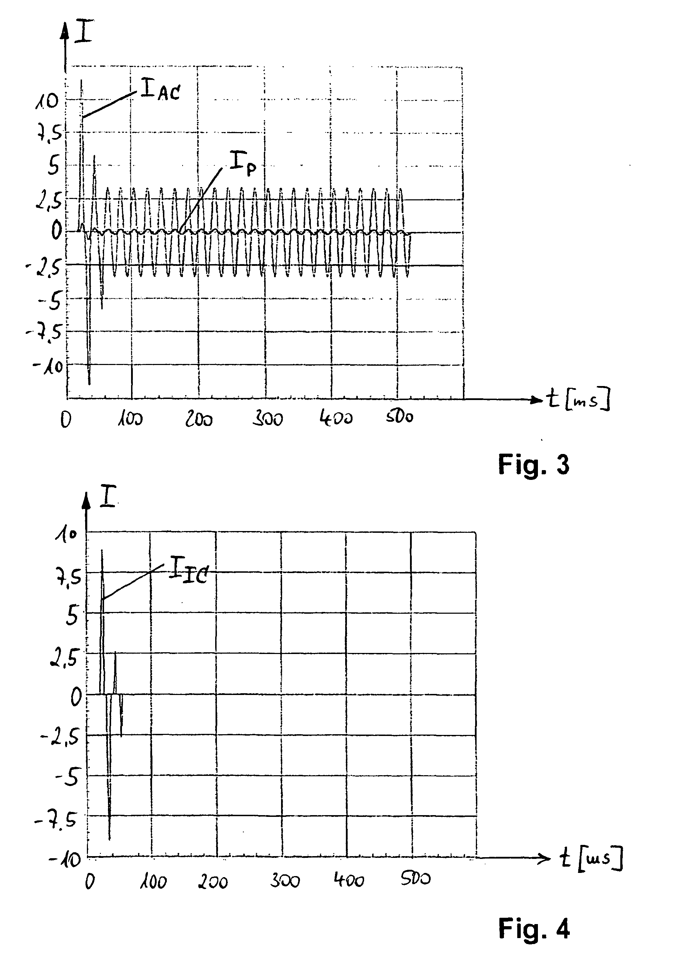

**Fig. 3** shows both the primary current I_{P} measured by an amperemeter **AM1** (Fig. 1) at the primary side and the AC current signal I_{AC} measured by an amperemeter **AM2** (Fig. 1) at the secondary side of the lamp transformer 5. The AC current signal I_{AC} is generated by both the lamp transformer 5 and the inrush current generator 10. When the primary signal voltage U_{P} is switched on at 0 ms, the AC current signal I_{AC} is initially increased up to a level sufficient to pull in the supervisory relay 6 of the relay interlocking system 1. After approximately 50 ms the AC current signal I_{AC} drops down to a steady current which is high enough to hold the supervisory relay 6.

**Fig. 4** shows the inrush current I_{IC} present in the AC current signal I_{AC} of Fig. 3 and measured by an amperemeter **AM3** (Fig. 1). As the inrush current generator 10 lowers the input resistance only for the first few waves of the alternating input voltage U_{S} and becomes ineffective afterwards, the inrush current I_{IC} decreases and disappears approximately 50 ms after the primary signal voltage U_{P} was switched on. In other words, the inrush current generator 10 emulates the inrush current of a conventional AC signal lamp and, therefore, makes it possible to use conventional relay interlocking systems also for a DC signal lamp 3.

## Claims

1. Inrush current generator (10) for a supervisory relay (6) of a relay interlocking system (1), comprising:
two generator connections (X1, X2) for connecting the inrush current generator (10) to an alternating input voltage (U_{S}), and
two electronic circuits (A1, A2), one for the positive and one for the negative half-wave of the alternating input voltage (U_{S}), comprising each:
a high gain low impedance switch (S1; S2) formed by at least one transistor (Q1; Q3) with reverse diode (D2; D4), each transistor (Q1, Q3) being connected to one generator connection (X1, X2) and to the other generator connection (X2, X1) via the reverse diode (D2; D4) of the other transistor (Q3; Q1), and
a capacitor (C1; C2) connected on the one side to one generator connection (X1, X2) via a resistor (R1; R4) and on the other side to the other generator connection (X2, X1) via a diode (D3; D1), for being loaded by the alternating input voltage (U_{S}) during the respective half-wave,
wherein the high gain low impedance switch (S1; S2) is switched on until the capacitor (C1; C2) is loaded to cause an inrush current (I_{IC}) between the two generator connections (X1, X2).

2. Inrush current generator according to claim 1, **characterized in that** the high gain low impedance switches (S1; S2) are each formed by both a Darlington transistor (Q1; Q3) with integrated reverse diode (D2; D4) and a transistor (Q2; Q4), the base of the transistor (Q2; Q4) being connected to the capacitor (C1; C2).

3. Inrush current generator according to claim 2, **characterized in that** the Darlington transistor (Q1; Q3) and the transistor (Q2; Q4) are of different pnp- and npn-types.

4. Inrush current generator according to any one of the preceding claims, **characterized in that** the two electronic circuits (A1, A2) are identical.

5. Relay interlocking system (1) comprising:
a lamp circuit (2) for driving a DC signal lamp (3),
an AC voltage source (5) for generating an AC current signal (I_{AC}) as control input for the lamp circuit (2),
a supervisory relay (6) connected in series to the lamp circuit (2), for supervising the AC current signal (I_{AC}) applied to the lamp circuit (2), and
an inrush current generator (10) according to any one of the preceding claims, connected in parallel with the lamp circuit (2), for generating an additional inrush current (I_{IC}) to increase the AC current signal (I_{AC}).

6. Relay interlocking system according to claim 5, **characterized in that** the AC voltage source is formed by the secondary side of a lamp transformer (5).

7. Relay interlocking system according to claim 5 or 6, **characterized in that** the DC signal lamp (3) is formed by one or more LEDs.

8. Method for supervising an AC current signal (I_{AC}) of a relay interlocking system (1), the AC current signal (I_{AC}) being applied to a lamp circuit (2) for driving a DC signal lamp (3),
wherein, when the AC current signal (I_{AC}) is switched on, the AC current signal (I_{AC}) is increased by an inrush current (I_{IC}) up to a level sufficient to pull in a supervisory relay (6) of the relay interlocking system (1) connected in parallel with the lamp circuit (2) and afterwards is high enough to hold the supervisory relay (6).

## Patentansprüche

1. Einschaltstromgenerator (10) für ein Überwachungsrelais (6) eines Relaisstellwerksystems (1), umfassend:
zwei Generatorverbindungen (X1, X2) zum Verbinden des Einschaltstromgenerators (10) mit einer Eingangswechselspannung (U_{S}), und
zwei elektronische Schaltungen (A1, A2), eine für die positive und eine für die negative Halbwelle der Eingangswechselspannung (U_{S}), jeweils umfassend:
einen Schalter (S1; S2) mit hoher Verstärkung und niedriger Impedanz, der von mindestens einem Transistor (Q1; Q3) mit Rückspeisediode (D2; D4) gebildet ist, wobei jeder Transistor (Q1, Q3) mit einer Generatorverbindung (X1, X2) und mit der anderen Generatorverbindung (X2, X1) über die Rückspeisediode (D2; D4) des anderen Transistors (Q3; Q1) verbunden ist, und
einen Kondensator (C1; C2), der einerseits mit einer Generatorverbindung (X1, X2) über einen Widerstand (R1; R4) und andererseits mit der anderen Generatorverbindung (X2, X1) über eine Diode (D3; D1) verbunden ist, um durch die Eingangswechselspannung (U_{S}) während der jeweiligen Halbwelle geladen zu werden,
wobei der Schalter (S1; S2) mit hoher Verstärkung und niedriger Impedanz angeschaltet ist bis der Kondensator (C1; C2) geladen ist, um einen Einschaltstrom (I_{IC}) zwischen den zwei Generatorverbindungen (X1, X2) zu bewirken.

2. Einschaltstromgenerator nach Anspruch 1, **dadurch gekennzeichnet, dass** die Schalter (S1; S2) mit hoher Verstärkung und niedriger Impedanz jeweils gebildet sind von sowohl einem Darlington Transistor (Q1; Q3) mit integrierter Rückspeisediode (D2; D4) als auch einem Transistor (Q2; Q4), wobei die Basis des Transistors (Q2; Q4) mit dem Kondensator (C1; C2) verbunden ist.

3. Einschaltstromgenerator nach Anspruch 2, **dadurch gekennzeichnet, dass** der Darlington Transistor (Q1; Q3) und der Transistor (Q2; Q4) von unterschiedlichen pnp und npn Typen sind.

4. Einschaltstromgenerator nach einem der vorhergehenden Ansprüche, **dadurch gekennzeichnet, dass** die zwei elektronischen Schaltungen (A1, A2) identisch sind.

5. Relaisstellwerksystem (1) umfassend:
eine Lampenschaltung (2) zum Steuern einer Gleichstrom-Kontrolllampe (3),
eine Wechselspannungsquelle (5) zum Erzeugen eines Wechselstromsignals (I_{AC}) als Steuereingang für die Lampenschaltung (2),
ein Überwachungsrelais (6), das mit der Lampenschaltung (2) in Reihe geschaltet ist zum Überwachen des Wechselstromsignals (I_{AC}), das an die Lampenschaltung (2) angelegt ist, und
einen Einschaltstromgenerator (10) nach einem der vorhergehenden Ansprüche, der mit der Lampenschaltung (2) parallel geschaltet ist, um einen zusätzlichen Einschaltstrom (I_{IC}) zu erzeugen, um das Wechselstromsignal (I_{AC}) zu erhöhen.

6. Relaisstellwerksystem nach Anspruch 5, **dadurch gekennzeichnet, dass** die Wechselspannungsquelle durch die Sekundärseite eines Lampen-Transformators (5) gebildet ist.

7. Relaisstellwerksystem nach Anspruch 5 oder 6, **dadurch gekennzeichnet, dass** die Gleichstrom-Kontrolllampe (3) von einer oder mehreren LEDs gebildet ist.

8. Verfahren zum Überwachen eines Wechselstromsignals (I_{AC}) eines Relaisstellwerksystems (1), wobei das Wechselstromsignal (I_{AC}) an eine Lampenschaltung (2) angelegt wird, um eine Gleichstrom-Kontrolllampe (3) zu steuern,
wobei, wenn das Wechselstromsignal (I_{AC}) angeschaltet ist, das Wechselstromsignal (I_{AC}) durch einen Einschaltstrom (I_{IC}) bis zu einem Level erhöht wird, der ausreicht, um ein Überwachungsrelais (6) des Relaisstellwerksystems (1), das mit der Lampenschaltung (2) parallel geschaltet ist, anzuziehen und danach hoch genug ist, um das Überwachungsrelais (6) zu halten.

## Revendications

1. Générateur de courant d'appel (10) pour un relais de supervision (6) d'un système d'enclenchement de relais (1), comprenant :
deux connexions de générateur (X1, X2) pour connecter le générateur de courant d'appel (10) à une tension d'entrée alternative (U_{S}), et
deux circuits électroniques (A1, A2), un pour la demi-onde positive et un pour la demi-onde négative de la tension d'entrée alternative (U_{S}), comprenant chacun :
un commutateur à gain élevé et faible impédance (S1 ; S2) formé par au moins un transistor (Q1 ; Q3) avec une diode inverse (D2 ; D4), chaque transistor (Q1 ; Q3) étant connecté à une connexion de générateur (X1, X2) et à l'autre connexion de générateur (X2, X1) via la diode inverse (D2 ; D4) de l'autre transistor (Q3 ; Q1), et
un condensateur (C1 ; C2) connecté à un côté à une connexion de générateur (X1, X2) via une résistance (R1 ; R4) et à l'autre côté à l'autre connexion de générateur (X2, X1) via une diode (D3 ; D1), pour être chargé par la tension d'entrée alternative (U_{S}) pendant la demi-onde respective,
dans lequel le commutateur à gain élevé et faible impédance (S1 ; S2) est activé jusqu'à ce que le condensateur (C1 ; C2) soit chargé pour générer un courant d'appel (I_{IC}) entre les deux connexions de générateur (X1, X2).

2. Générateur de courant d'appel selon la revendication 1, **caractérisé en ce que** les commutateurs à gain élevé et faible impédance (S1 ; S2) sont chacun formés par un transistor Darlington (Q1 ; Q3) avec une diode inverse intégrée (D2 ; D4) et un transistor (Q2 ; Q4), la base du transistor (Q2 ; Q4) étant connectée au condensateur (C1 ; C2).

3. Générateur de courant d'appel selon la revendication 2, **caractérisé en ce que** le transistor Darlington (Q1 ; Q3) et le transistor (Q2 ; Q4) sont de types pnp et npn différents.

4. Générateur de courant d'appel selon l'une quelconque des revendications précédentes, **caractérisé en ce que** les deux circuits électroniques (A1, A2) sont identiques.

5. Système d'enclenchement de relais (1) comprenant :
un circuit à lampe (2) pour exciter une lampe à signal C.C. (3),
une source de tension C.A. (5) pour générer un signal de courant C.A. (I_{AC}) en tant qu'entrée de commande pour le circuit à lampe (2),
un relais superviseur (6) connecté en série au circuit à lampe (2), pour superviser le signal de courant C.A. (I_{AC}) appliqué au circuit à lampe (2), et
un générateur de courant d'appel (10) selon l'une quelconque des revendications précédentes, connecté en parallèle avec le circuit à lampe (2), pour générer un courant d'appel additionnel (I_{IC}) pour augmenter le signal de courant C.A. (I_{AC}).

6. Système d'enclenchement de relais selon la revendication 5, **caractérisé en ce que** la source de tension C.A. est formée par le côté secondaire d'un transformateur à lampe (5).

7. Système d'enclenchement de relais selon la revendication 5 ou 6, **caractérisé en ce que** la lampe de signal C.A. (3) est formée par une ou plusieurs LED.

8. Procédé pour superviser un signal de courant C.A. (I_{AC}) d'un système d'enclenchement de relais (1), le signal de courant C.A. (I_{AC}) étant appliqué à un circuit de lampe (2) pour exciter une lampe de signal C.A. (3),
dans lequel, lorsque le signal de courant C.A. (I_{AC}) est activé, le signal de courant C.A. (I_{AC}) est augmenté par un courant d'appel (I_{IC}) jusqu'à un niveau suffisant pour accrocher un relais de supervision (6) du système d'enclenchement de relais (1) connecté en parallèle au circuit à lampe (2) et est ensuite suffisamment élevé pour maintenir le relais de supervision (6).
